# EUROPÄISCHE PATENTANMELDUNG

(11) **EP 1 148 368 A2**
(43) Veröffentlichungstag der Anmeldung: **24.10.2001**
(21) Anmeldenummer: 01102862.8
(22) Anmeldetag: 14.02.2001
(51) Int. Cl.: G02B 7/02

(54) **Vorrichtung zum Verbinden von Gehäusen oder Fassungen für optische Elemente**

(30) Priorität: 20.04.2000 DE 10019562
(71) Anmelder: Carl Zeiss, 89518 Heidenheim (Brenz) (DE)
(72) Erfinder: Moennig, Thomas, 73460 Huettlingen (DE)
(74) Vertreter: Lorenz, Werner, Dr.-Ing.

(57) **Zusammenfassung**

Eine Vorrichtung zum Verbinden von Gehäusen oder Fassungen (4) für optische Elemente (13), insbesondere für Linsen in Objektiven (12) für Halbleiter-Projektionsbelichtungsanlagen, ist mit Elektro-Permanentmagneten (1) versehen, wobei die Elektro-Permanentmagnete durch das Magnetfeld einer mit einer Ansteuereinrichtung (8) verbundenen Spule (5) derart aufmagnetisiert sind, daß die Gehäuse oder Fassungen (4) durch Magnetkräfte miteinander verbunden sind.

## Beschreibung

Die Erfindung betrifft eine Vorrichtung zum Verbinden von Gehäusen oder Fassungen mit anderen Gehäusen oder Fassungen für optische Elemente, insbesondere für Linsen in Objektiven für Halbleiter-Lithographie-Projektionsbelichtungsanlagen.

Fassungen von Linsen zur Bildung eines Objektives werden im allgemeinen durch eine Vielzahl von über den Umfang verteilt angeordneten Schrauben miteinander verbunden. Durch die Anzugskräfte der Schraubverbindungen ergeben sich jedoch bestimmte Deformationen der Fassung und somit der Linsen bzw. der Optik. Insbesondere entsteht auf diese Weise in Abhängigkeit von der Anzahl der Schrauben eine Welligkeit, die sich auf das optische Element, z.B. eine Linse, negativ auswirkt. Die Deformation der Optik findet zwar im allgemeinen nur im Nanometer-Bereich statt, aber diese Deformation ist z.B. in Projektions-Belichtungsanlagen der Halbleiter-Lithographie unter Umständen problematisch.

Der vorliegenden Erfindung liegt die Aufgabe zugrunde, eine Verbindungstechnik für Fassungen und Gehäusen von optischen Elementen zu schaffen, durch die sich keine negativen Auswirkungen auf die Optik ergeben.

Erfindungsgemäß wird diese Aufgabe durch die in Anspruch 1 genannten Merkmale gelöst.

Elektro-Permanentmagnete werden bisher in der Fertigungstechnik als Spannelemente verwendet, um Werkstücke für einen Bearbeitungsvorgang festzuhalten und anschließend nach Bearbeitung des Werkstückes diese wieder freizugeben. Elektro-Permanentmagnete kombinieren die wesentlichen Konstruktionsmerkmale von Elektrosystemen mit denen von reinen Permanentsystemen. Zusätzlich zu Permanentmagneten ist eine Erregerspule vorgesehen. Nach dem Einschalten der Erregerspule werden die zunächst magnetisch neutralen Permanentmagnete durch das Magnetfeld der Spule aufmagnetisiert. Nachdem dieser Aktivierungsvorgang stattgefunden hat, kann die Stromzuführung getrennt werden. Das Magnetfeld und somit die Magnetkräfte werden anschließend ausschließlich durch die Wirkung der Permanentmagnete erzeugt. Während des gesamten Spann- und Bearbeitungsvorganges zum Bearbeiten des Werkstückes ist deshalb keinerlei weitere Energiezufuhr erforderlich. Die Kabelverbindung zwischen Magnet und Steuerteil wird nach der Magnetansteuerung getrennt.

Es wurde nun in erfinderischer Weise erkannt, daß man das Prinzip von Elektro-Permanentmagneten als eigentliche Spanngeräte auch zum dauerhaften Verbinden von Fassungen und Gehäusen für optische Elemente verwenden kann, wenn diese in geeigneter Weise in Fassungen oder Gehäusen integriert oder mit den Fassungen oder Gehäusen verbunden werden.

Einer der Hauptvorteile der erfindungsgemäßen Vorrichtung liegt darin, daß man Fassungen und Gehäuse während der Montage exakt zueinander justieren kann, wobei während des Justiervorganges nur ganz geringe oder überhaupt keine Haftkräfte vorhanden sind. Dies bedeutet, die einzelnen Teile des Objektives lassen sich exakt verschieben, um z.B. die optische Achse genau einstellen zu können. Erst nach Beendigung des Justiervorganges wird der Elektro-Permanentmagnet durch die Spule aufmagnetisiert und erhält auf diese Weise seine Haftkraft zur exakten Verbindung der einzelnen Fassungen oder Gehäuse miteinander. Die ausgewählte Haftkraft bleibt langfristig erhalten.

Ein weiterer Vorteil der erfindungsgemäßen Vorrichtung besteht darin, daß man die Spannkraft durch eine entsprechende Ansteuerung der Spule sehr genau steuern und einstellen kann.

Erfindungsgemäß können durch die Elektro-Permanentmagnete Schraubverbindungen entfallen, wodurch gleichzeitig neben einer Vermeidung von Deformationen der Optik auch die Montagezeit deutlich verkürzt wird. Darüber hinaus müssen Fassungen oder Gehäuse in der Vorfertigung nicht mehr gebohrt und keine Gewinde geschnitten werden, wodurch auch unterbrochene Schnitte entfallen können. Weiterhin sind keine Hinterdrehungen von Außenfassungen für Schrauben mehr erforderlich. Über den Umfang verteilte Welligkeiten des optischen Elementes werden vollständig vermieden, da keine unregelmäßigen Verspannungen durch die Schraubverbindung mehr auftreten.

Ein weiterer Vorteil der erfindungsgemäßen Vorrichtung besteht darin, daß z.B. Linsenfassungen ohne irgendwelche Bohrungsbegrenzungen in beliebiger Weise um jeden Winkel gedreht und verschoben werden können. Dies ist besonders von Vorteil zur Objektivabstimmung bei systematischen Justierungsprozessen.

In einer vorteilhaften konstruktiven Ausgestaltung der Erfindung kann vorgesehen sein, daß z.B. Fassungen oder Gehäuse mit Aussparungen versehen sind, in denen jeweils ein Elektro-Permanentmagnet angeordnet ist, oder daß jeweils zwischen zwei Fassungen oder Gehäusen ein Abstimmring mit einem ringförmigen Elektro-Permanentmagneten angeordnet ist.

Je nach Anordnung der Elektro-Permanentmagnete und gegebenenfalls von Zwischenringen können die Fassungen magnetisch oder nicht magnetisch sein.

Eine sehr vorteilhafte Weiterbildung mit einem gleichzeitig neuem Anwendungsfall ergibt sich, wenn durch eine Ausgestaltungsform von Planflächen, auf die die Magnetkraft einwirkt, das optische Element als Manipulator in z-Richtung ausgebildet ist.

Durch diese Ausgestaltung wird die Möglichkeit gegeben ein Objektiv bezüglich seiner optischen Abbildung zu verändern bzw. zu beeinflussen. Mit Hilfe einer spezifischen Ausgestaltung von Planflächen, z.B. in Form von offenen Keilflächen oder abgestuften Ringflächen, die mit am inneren Umfang frei überstehenden Teilbereichen versehen sind, kann das dazugehörige optische Element, z.B. eine Linse, gezielt verformt werden. Aufgrund der überstehenden Teilbereiche wird eine Verbiegung über die induzierte Magnetkraft aufgebracht und diese Verbiegung wirkt somit auch in gleicher Weise auf das optische Element ein, womit man eine gezielte Deformation als z-Manipulator erreichen kann.

Vorteilhafte Ausgestaltungen und Weiterbildungen ergeben sich aus den übrigen Unteransprüchen und aus den nachfolgend anhand der Zeichnung prinzipmäßig beschriebenen Ausführungsbeispielen.

### Es zeigt:

- Figur 1: eine vergrößerte Prinzipdarstellung eines in ein Gehäuse, z.B. in eine Linsenfassung eines Objektives eingebauten Elektro-Permanentmagneten,
- Figur 2: Elektro-Permanentmagnete, die in Linsenfassungen eingebaut sind,
- Figur 3: mehrere in Linsenfassungen eingebaute Elektro- Permanentmagnete mit dazwischen liegenden Abstimm- ringen, wobei die Abstimmringe magnetisierbar sind,
- Figur 4: zwei in einen Abstimmring eingebaute Elektro- Permanentmagneten,
- Figuren 5a bis 5c: Prinzipdarstellungen eines Elektro-Permanentmagneten als Manipulator, und
- Figur 6: eine Fassungstechnik mit einem Elektro- Permanentmagneten für eine Korrekturlinse.

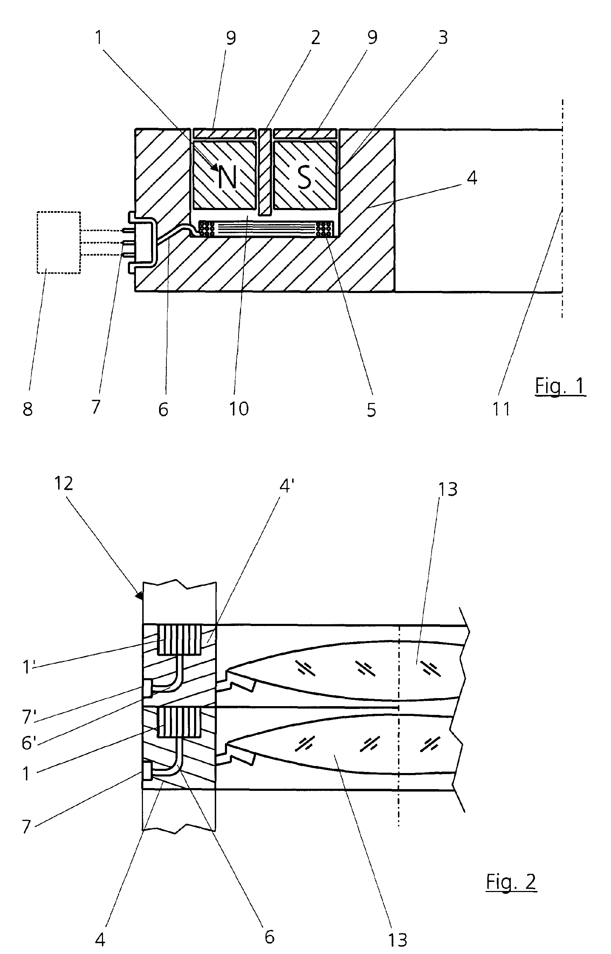

In der Figur 1 ist in einer Prinzipdarstellung ein Elektro-Permanentmagnet 1 mit Ringpolteilung durch ein Trennblech 2, z.B. aus Messing, dargestellt. Hierzu weist der Elektro-Permanentmagnet einen ringförmigen Nordpol und einen ringförmigen Südpol auf. Der Elektro-Permanentmagnet 1 ist in eine Aussparung 3 eines Gehäuses, z.B. eine Linsenfassung 4 eingebaut. In der Aussparung 3 befindet sich unter den beiden Polringen, die z.B. als ALNi-Cobaltmagnete ausgebildet sein können, ein Spulenkörper 5, der über Anschlüsse 6 und eine Ansteuerung 7 mit einer Ansteuereinrichtung 8 (gestrichelt dargestellt) zu dessen Erregung verbunden ist. Nach der erfolgten Magnetansteuerung wird die Steckerverbindung getrennt. Die vorher eingegebene Haftkraft bleibt erhalten.

Jeweils eine Abschlußplatte 9 schließt die beiden Magnetpolringe auf der Oberseite der Aussparung 3 ab. Die Gegenfassung besteht aus magnetisierbarem Stahl. Erst die obere Verbindungsfläche besteht wiederum aus den beschriebenen Magnetpolringen.

Wie aus der Prinzipdarstellung der Figur 2 ersichtlich ist, können die Linsenfassungen 4 und 4' Teile eines nicht näher dargestellten Objektives 12, z.B. für eine Halbleiter-Lithographie-Projektionsbelichtungsanlage sein.

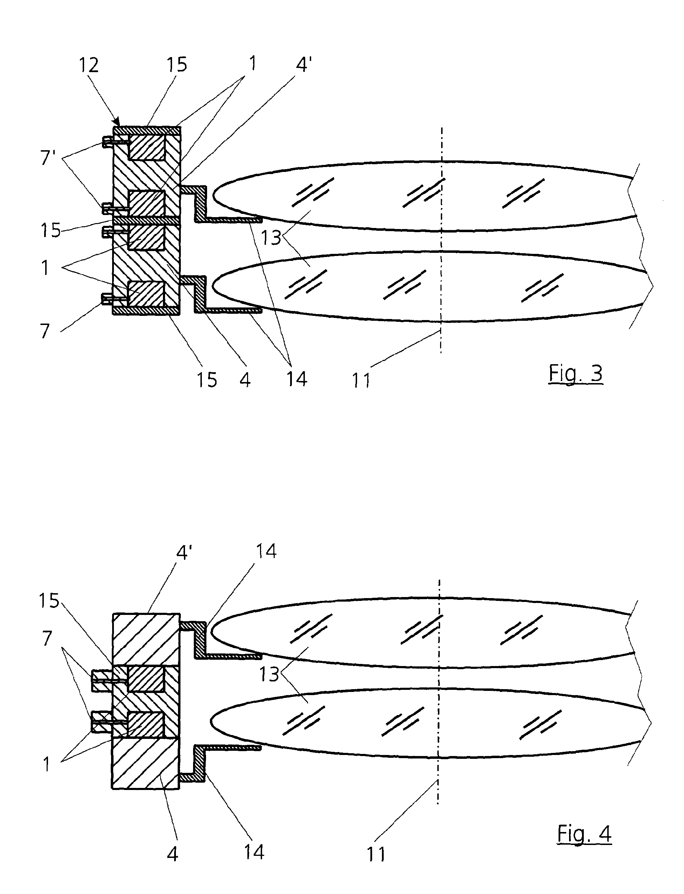

Die Figur 3 zeigt eine ähnliche Ausgestaltung einer Vorrichtung zum Verbinden von zwei Fassungen 4 für Linsen eines ebenfalls nur teilweise dargestellten Objektives 12. Wie ersichtlich, weisen dabei die Fassungen 4, 4' im Querschnitt gesehen jeweils eine H-Form auf, wobei in den dabei entstandenen Aussparungen jeweils einen Elektro-Permanentmagnet 1 angeordnet ist, der über die, in diesem Falle nicht mehr näher dargestellte Ansteuerung 7 mit der dazugehörigen Ansteuereinrichtung 8 (hier nicht dargestellt) verbunden ist.

Zur genauen Abstandseinstellung der Linsen 13 ist zwischen den beiden Fassungen 4, 4' ein Abstimmring 15 angeordnet. Bei dem in der Figur 3 dargestellten Ausführungsbeispiel wird man den Abstimmring 15 aus einem magnetischen Werkstoff wählen, um die Haftkraft zwischen den Fassungen 4, 4' zu erzeugen, während man die Fassungen 4, 4' selbst aus einem nicht magnetischen Werkstoff (z.B. Keramik) wählen kann. Gleiches gilt auch für die anderen Bauteile.

In der Figur 4 ist ein Ausführungsbeispiel dargestellt, wobei zwei Elektro-Permanentmagnete 1 in einen Abstimmring 15 eingesetzt sind. Hierzu ist der Abstimmring 15 in H-Form ausgebildet und in die beiden Aussparungen 3 ist jeweils ein Elektro-Permanentmagnet 1 eingesetzt. Bei einer Aktivierung der Elektro-Permanentmagnete 1 werden über den Abstimmring 15 die beidseits angeordneten Linsenfassungen 4, 4', die hierzu aus einem magnetischen Werkstoff bestehen, durch die entstehende Magnetkraft unverrückbar getrennt voneinander verbunden.

Anstelle einem Einbau des Spulenkörpers 5 in die Aussparung kann dieser zur Aktivierung der Elektro-Permanentmagnete 1 im Bedarfsfall auch an einer anderen Stelle angeordnet sein.

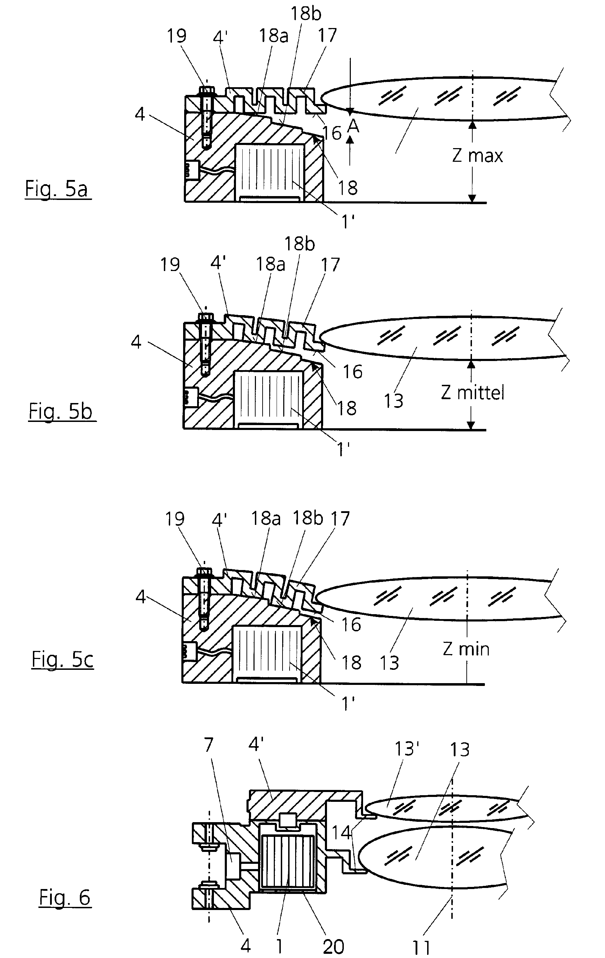

In den Figuren 5a bis 5c ist lediglich prinzipmäßig dargestellt, wie man über einen oder auch mehrere Elektro-Permanentmagnete 1 aus einer Linsenfassung 4 oder auch aus einem anderen Gehäuseteil mit einem optischen Element, z.B. einer Linse 13, einen Manipulator erzeugen kann, durch den Verschiebungen in z-Richtung möglich werden. Durch den Elektro-Permanentmagnet 1 lassen sich z-Fokussierungen einer Linse 13 im feinsten Bereich erzeugen. Wie ersichtlich, ist hierzu eine Planfläche 16 einer Fassung oder eines Gehäuses 4', auf den die Magnetkräfte des oder der Elektro-Permanentmagnete 1' einwirken, am inneren Umfang mit einem elastisch nachgiebigen Teilbereich 17 frei überstehend gegenüber einer Auflagefläche 18 des benachbart bzw. darunter liegenden Gehäuse- oder Fassungsteil ausgebildet. Der überstehende Teilbereich 17 kann sich konzentrisch über den gesamten Umfang verteilen oder auch in Form von asymmetrischen (in Form einer aktiven Linse (ALE) Activ Lens Element) oder symmetrischen Aussparungen ausgebildet sein.

Durch die Anordnung eines Elektro-Permanentmagneten 1' in dem Bereich der Auflagefläche 18 der darunter angeordneten Linsenfassung 4 wird bei dessen Aktivierung eine Magnetkraft auf den überstehenden Teilbereich 17 ausgeübt. Entsprechend der Magnetkraft biegt sich der überstehende Teilbereich elastisch nachgiebig durch, womit die Linse 13 um ein entsprechendes Maß in z-Richtung verschoben wird. Zwar werden dabei nur Verschiebungen im um-Bereich möglich, aber für Halbleiter-Lithographie-Projektionsbelichtungsanlagen stellt diese Manipulation eine sehr zweckmäßige Ausgestaltung und sinnvolle Verschiebung dar, um die geforderte hohe Präzision eines Objektives zu erreichen. Der Elektro-Permanentmagnet 1' kann in diesem Falle zusätzlich zu dem Elektro-Permanentmagnet 1 vorhanden sein, der die Verbindung und die radiale Justierung von benachbarten Fassungen 4, 4' herstellt.

Zur radialen Ausrichtung der Fassungen 4 und 4' vor Aktivierung der Elektro-Permanentmagnete 1 können in bekannter Weise Radialtastspuren am äußeren Umfang der Fassungen 4, 4' dienen.

Die Auflagefläche 18 kann konisch, keilförmig oder auch stufenförmig ausgebildet sein. Eine stufenförmige Ausbildung - wie dargestellt - mit ringförmigen Stufen 18a und 18b hat den Vorteil, daß z.B. bei einem überstehenden Teilbereich 17 in Mäanderform größere Auflagebereiche bei einer Manipulation der Linse 13' geschaffen werden, die eine definierte Auflage aufweisen.

Die Figur 5a zeigt die Ausgangssituation, wobei die Haftkraft noch Null beträgt und der Abstand der Linse 13 zur Unterkante der Fassung 4 zₘₐₓ beträgt. Die maximale Verschiebung der Linse 13 in z-Richtung beträgt A.

Die Figur 5b zeigt eine Haftkraft mit einer angenommenen ersten Stufe, wobei der überstehende Teilbereich 17 mit seiner Planfläche 16 der Fassung 4' an der ersten Stufe 18a anschlägt. Der Abstand der Linse 13 zur Unterkante der Fassung 4 beträgt dabei Zₘᵢₜₜₑₗ.

Figur 5c zeigt die größte Haftkraftstufe, wobei sich der elastische Teilbereich 17 mit seiner Planfläche 16 zusätzlich auch noch an der Stufe 18b anlegt. Der Abstand der Linse 13 von der Unterkante der Fassung 4 beträgt in diesem Fall zₘᵢₙ. Der innere Bereich der Auflagefläche 18, der ebenfalls abgestuft ist gegenüber der Stufe 18b besitzt gegenüber dem Teilbereich 17 einen Abstand, so daß eine kraftfreie elastische Lagerung der Linse 13 verbleibt. Die Fassung 4' bzw. das Gehäuseteil und die Fassung 4 können durch Schraubverbindungen 19 miteinander verbunden sein. Selbstverständlich ist es jedoch auch möglich, daß zusätzlich zu dem Elektro-Permanent-magneten 1' im radialen äußeren Bereich noch ein zweiter ringförmiger Elektro-Permanentmagnet 1 angeordnet ist, der nach seiner Aktivierung die Fassungen 4 und 4' miteinander verbindet.

In der Figur 6 ist die Verwendung eines Elektro-Permanent-magneten 1 in der Fassungstechnik für eine Korrekturlinse 13'' prinzipmäßig dargestellt. In diesem Falle ist die Fassung 4 für die normalen Linsen in herkömmlicher Weise über eine Verschraubungstechnik miteinander verbunden. Selbstverständlich können jedoch auch für die herkömmlichen Linsen 13 Elektro-Permanentmagnete 1 zur Verbindung verwendet werden. Mit der erfindungsgemäßen Verbindung der Fassung 4' für die Korrekturlinse 13' mit der darunterliegenden Fassung 4 wird eine reproduzierbare Trennstelle erreicht. Die darunterliegenden Fassung 4 ist hierzu mit dem Elektro-Permanentmagneten 1 versehen.

Bei einer erneuten Montage der Korrekturlinse 13'' nach einem Feinbearbeitungsschritt soll sich kein weiterer, neuer Fehler einschleichen. Dies wird im Unterschied zu einer Verbindung über eine Schraubtechnik nunmehr durch die Verbindung mit dem Elektro-Permanentmagneten 1 erreicht, denn es können keine neuen Veränderungen auftreten, wie dies bei der herkömmlichen Schraubtechnik der Fall ist. Die Einbauöffnung für den Elektro-Permanentmagneten 1 ist in diesem Falle durch eine Abschlußplatte 20 verschlossen.

## Patentansprüche

1. Vorrichtung zum Verbinden von Gehäusen oder Fassungen für optische Elemente, insbesondere für Linsen (13) in Objektiven (12) für Halbleiter-Lithographie-Projektionsbelichtungsanlagen, mittels Elektro-Permanentmagneten (1), wobei die Elektro-Permanentmagnete durch das Magnetfeld einer mit einer Ansteuereinrichtung (8) verbundenen Spule (5) derart aufmagnetisiert sind, daß die Fassungen oder Gehäuse (4,4') durch Magnetkraft miteinander verbunden sind.

2. Vorrichtung nach Anspruch 1, **dadurch gekennzeichnet, daß** die Fassungen oder Gehäuse (4,4') mit Aussparungen (3,3') versehen sind, in denen jeweils ein Elektro-Permanentmagnet (1) angeordnet ist.

3. Vorrichtung nach Anspruch 1 und 2, **dadurch gekennzeichnet, daß** jeweils zwischen zwei Fassungen oder Gehäuse (4,4') ein Abstimmring (15) mit wenigstens einem Elektro-Permanent-magneten (1) angeordnet ist.

4. Vorrichtung nach Anspruch 3, **dadurch gekennzeichnet, daß** die Fassungen oder Gehäuse (4,4') magnetisch sind.

5. Vorrichtung nach einem der Ansprüche 1 bis 4, **dadurch gekennzeichnet, daß** zwischen den Fassungen oder Gehäuse (4,4') jeweils ein Abstimmring (15) aus magnetischem Werkstoff angeordnet ist.

6. Vorrichtung nach einem der Ansprüche 1 bis 5, **dadurch gekennzeichnet, daß** durch eine Ausgestaltungsform von Planflächen (16) des Gehäuses oder der Fassung, auf die die Magnetkraft einwirkt, das optische Element (13) als Manipulator in z-Richtung vorgesehen ist.

7. Vorrichtung nach Anspruch 6, **dadurch gekennzeichnet, daß** wenigstens eine Planfläche (16) wenigstens annähernd als Ringfläche ausgebildet ist, die mit wenigstens teilweise über Umfangsbereiche am Innenumfang gegenüber einer Auflagefläche (18) eines benachbart liegenden Gehäuse- oder Fassungsteiles frei überstehenden elastisch nachgiebigen Teilbereichen (17) versehen ist.

8. Vorrichtung nach Anspruch 7, **dadurch gekennzeichnet, daß** die Teilbereiche (17) durch eine Mäanderform gebildet sind.

9. Vorrichtung nach Anspruch 7 oder 8, **dadurch gekennzeichnet, daß** die Auflagefläche (18) keilförmig oder mit Stufen (18a,18b) ausgebildet ist.

10. Vorrichtung nach einem der Ansprüche 1 bis 5, **dadurch gekennzeichnet, daß** die Fassung oder das Gehäuse (4,4') für eine Korrekturlinse (13) vorgesehen ist.

11. Verwendung von Elektro-Permanent-Magneten (1) zum Verbinden von Fassungen oder Gehäusen (4,4') für optische Elemente, insbesondere für Linsen (13) in Objektiven (12) für Halbleiter-Lithographie-Projektionsbelichtungsanlagen.
